# EUROPEAN PATENT APPLICATION

(11) **EP 4 224 529 A1**
(43) Date of publication of application: **09.08.2023**
(21) Application number: 20959057.9
(22) Date of filing: 28.10.2020
(51) Int. Cl.: H01L 27/146

(54) **MULTICHIP PACKAGING STRUCTURE, MANUFACTURING METHOD, AND ELECTRONIC DEVICE**

(71) Applicant: Huawei Technologies Co., Ltd., Shenzhen, Guangdong 518129 (CN)
(72) Inventor: LI, Heng, Shenzhen, Guangdong 518129 (CN); ZHANG, Xiaodong, Shenzhen, Guangdong 518129 (CN); WANG, Jing, Shenzhen, Guangdong 518129 (CN); ZUO, Wenming, Shenzhen, Guangdong 518129 (CN); ZHANG, Juan, Shenzhen, Guangdong 518129 (CN); ZHOU, Xu, Shenzhen, Guangdong 518129 (CN)
(74) Representative: Epping - Hermann - Fischer
(86) International application number: PCT/CN2020/124424
(87) International publication number: WO 2022/087894

(57) **Abstract**

A multi-chip package structure (300, 400, 500, 600), a manufacturing method, and an electronic device are provided to improve flexibility of multi-chip packaging, and further implement miniaturization of electronic device packaging. The package structure (300, 400) sequentially includes a first die layer (301), a second die layer (302), and a third die layer (303) from top to bottom. A plurality of hybrid bonding structures (305) are disposed between the first die layer (301) and the second die layer (302); a plurality of TSVs (307) that penetrate the second die layer (302) are disposed at the second die layer (302); and a plurality of solder bumps (306) are disposed between the third die layer (303) and the second die layer (302).

## Description

### TECHNICAL FIELD

This application relates to the field of electronic packaging, and in particular, to a multi-chip package structure, a manufacturing method, and an electronic device.

### BACKGROUND

In recent years, with development of a trend of miniaturization and portability of a device, a chip packaging technology gradually develops towards a 3-dimensional (3 dimensions, 3D) stacking manner. Modules are disposed at a planar layer in a conventional 2-dimensional (2 dimensions, 2D) chip. In a 3D chip, a plurality of layers are allowed to be stacked, and signal connections of a plurality of dies (dies) in a vertical direction are provided by using a through silicon via (through silicon via, TSV). A 3D packaging technology may be used for micro-system integration, and is usually presented as a system in package (system in package, SIP). For example, the 3D packaging technology may be applied to the fields such as an image sensor and a memory.

Although the 3D packaging technology is a hot development direction in the industry, the 3D packaging technology also faces a problem of compromising between an area, costs, and performance. For example, to ensure that electrical connections can be smoothly implemented between chips in a 3D package, processes and sizes of chips at all layers of the 3D package are required to be consistent, and a wafer-to-wafer (wafer to wafer, W2W) connection manner is used. The connection manner requires a high yield rate, and a conventional technology node (technology node) usually needs to be used for the high yield rate. If a technology node is more conventional, a chip provides fewer functions in a same area, and power consumption is higher. As a result, flexibility of the 3D package is low, and costs are high. In addition, because functions implemented by a conventional 3D package structure are limited, some functions need to be completed by relying on a system on chip (system on chip, that is, SoC), and a large quantity of signals are transmitted to the SoC through a mainboard for processing. This signal processing manner is limited by bandwidth of the mainboard and a processing capability of the SoC. This reduces data processing efficiency and increases load of the SoC.

### SUMMARY

This application provides a multi-chip package structure, a manufacturing method, and an electronic device to resolve at least one of the foregoing disadvantages.

According to a first aspect, a multi-chip package structure is provided. The package structure sequentially includes a first die layer, a second die layer, and a third die layer from top to bottom. The first die layer includes at least one first die, the second die layer includes at least one second die, and the third die layer includes at least one third die. A plurality of hybrid bonding structures are disposed between the first die layer and the second die layer to enable the first die layer to be electrically connected to the second die layer by using at least one hybrid bonding structure. A plurality of through silicon vias TSV that penetrate the second die layer are disposed at the second die layer, a plurality of solder bumps are disposed between the third die layer and the second die layer, and the first die layer is electrically connected to the third die layer by using at least one hybrid bonding structure, at least one TSV electrically connected to the at least one hybrid bonding structure, and at least one solder bump electrically connected to the at least one TSV

The first die layer is connected to the second die layer in a hybrid bonding manner. The third die layer is connected to the second die layer by using the solder bump. The first die layer is electrically connected to the third die layer by using the hybrid bonding structure, the plurality of TSVs, and the plurality of solder bumps. Stacked packaging of different processes and chips is implemented by combining the hybrid bonding structure, the solder bump, and the TSV Packaging of dies of different sizes and processes at the second die layer and the third die layer can be supported by using the solder bumps, flexibility of multi-chip packaging can be improved, and miniaturization of electronic device packaging can be further implemented.

Optionally, a feature size of a process used for the third die layer is smaller than that of the first die layer and that of the second die layer. Optionally, the third die layer includes a circuit used for edge computing. Further, optionally, the package structure is applied to an image sensor, the first die layer includes a chip on which an optical device is disposed, and the second die layer includes a logic chip.

In the multi-chip package structure, the feature size of the process used for the third die layer is smaller than that of the first die layer and that of the second die layer. Therefore, the third die layer has a smaller area and can integrate more functions. For a case in which an area and the process of the third die layer are different from those of another die layer, the third die layer is connected to the second die layer by using the solder bump. In this package structure, the third die layer may include the circuit that provides an edge computing function. The edge computing is computing performed by a signal collection end to process information. Therefore, the package structure may locally process at least some signals, and this can reduce an amount of data transmitted between the third die layer and a SoC. In addition, because the multi-chip package structure is no longer affected by transmission bandwidth, efficiency of locally processing data by the multi-chip package structure can be improved, and power consumption can be reduced. In the conventional technology, the edge computing function is completed by relying on the SoC, and a signal is transmitted to the master chip SoC through a mainboard for processing. This signal processing manner is limited by bandwidth of the mainboard and a processing capability of the SoC. In addition, all signals need to be transmitted to the SoC, and this increases a signal transmission amount and load of the SoC. On the contrary, in the technical solutions of this application, the third die layer may include the circuit that provides the edge computing function, and a large amount of data is quickly processed locally. This reduces the load of the SoC and the signal transmission amount. More importantly, the large amount of data is processed locally, which is not limited by transmission bandwidth of the SoC and is more efficient.

Optionally, the multi-chip package structure may alternatively include more than three die layers.

With reference to the first aspect, in a possible implementation, the package structure further includes a metal layer disposed at the second die layer. The plurality of TSVs are electrically connected to the metal layer; and the first die layer is electrically connected to the third die layer by using the at least one hybrid bonding structure, the metal layer electrically connected to the at least one hybrid bonding structure, at least one TSV electrically connected to the metal layer, and at least one solder bump electrically connected to the at least one TSV

With reference to the first aspect, in a possible implementation, the second die layer is electrically connected to the third die layer by using the metal layer, the at least one TSV electrically connected to the metal layer, and the at least one solder bump electrically connected to the at least one TSV

The third die layer is connected to the second die layer by using the solder bump, the metal layer, and the TSV Stacked packaging of different processes and chips is implemented by combining the hybrid bonding structure, the solder bump, the metal layer, and the TSV Packaging of dies of different sizes and processes can be supported, and flexibility of multi-chip packaging can be improved.

With reference to the first aspect, in a possible implementation, the third die layer includes two third dies. The two third dies are sequentially connected by using at least one solder bump, at least one TSV electrically connected to the at least one solder bump, the metal layer electrically connected to the at least one TSV, at least one other TSV electrically connected to the metal layer, and at least one other solder bump electrically connected to the at least one other TSV

The at least one solder bump and the at least one other solder bump separately correspond to different third dies.

Optionally, the third die layer may include a plurality of third dies, and the two third dies may be any two of the plurality of third dies.

With reference to the first aspect, in a possible implementation, a redistribution layer RDL is disposed at the second die layer. The first die layer is electrically connected to the third die layer by using at least one hybrid bonding structure, at least one TSV electrically connected to the at least one hybrid bonding structure, the RDL electrically connected to the at least one TSV, and at least one solder bump electrically connected to the RDL.

The RDL is disposed at the second die layer, so that signal transmission can be implemented between the second die layer and the third die layer or between a plurality of third dies at the third die layer by using the RDL, to reduce a quantity of TSVs disposed at the second die layer. This can reduce process steps and area overheads of the TSV, improve signal bandwidth and signal quality, and improve heat dissipation performance of the chip.

Optionally, the RDL may be implemented by using polyimide (polymide). Alternatively, copper interconnection may be implemented by using a Damascus process, or aluminum interconnection may be implemented. The foregoing materials can reduce product costs and have a strong power supply capability.

Optionally, when the multi-chip package structure is applied to a scenario that has a high requirement on a signal frequency, the RDL may be disposed at the second die layer. When the multi-chip package structure is applied to a scenario that has a low requirement on a signal frequency, the RDL may not need to be disposed. This reduces process costs and design complexity.

With reference to the first aspect, in a possible implementation, the second die layer is electrically connected to the third die layer by using the RDL and the at least one solder bump electrically connected to the RDL.

With reference to the first aspect, in a possible implementation, the third die layer includes two third dies. The two third dies are electrically sequentially connected by using at least one solder bump, the RDL electrically connected to the at least one solder bump, and at least one other solder bump electrically connected to the RDL.

With reference to the first aspect, in a possible implementation, the plurality of TSVs are electrically connected to a metal layer disposed at the second die layer. The first die layer is electrically connected to the third die layer by using the at least one hybrid bonding structure, the metal layer electrically connected to the at least one hybrid bonding structure, at least one TSV electrically connected to the metal layer, the RDL electrically connected to the at least one TSV, and at least one solder bump electrically connected to the at least one TSV

With reference to the first aspect, in a possible implementation, the first die layer includes any one of the following types of chips: a chip disposed with an optical device; a chip disposed with a static random access memory SRAM; a chip disposed with a dynamic random access memory DRAM; a chip disposed with an application-specific integrated circuit ASIC; and a logic chip, where an algorithm processing circuit is disposed in the logic chip.

With reference to the first aspect, in a possible implementation, the second die layer includes any one of the following types of chips: a chip disposed with an SRAM; a chip disposed with a DRAM; a chip disposed with an ASIC; and a logic chip, where an algorithm logic circuit is disposed in the logic chip.

With reference to the first aspect, in a possible implementation, the third die layer includes any one of the following types of chips: a chip disposed with an ASIC; a chip disposed with a DRAM; a chip disposed with an SRAM; and a logic chip, where an algorithm logic circuit is disposed in the logic chip.

According to a second aspect, a method for manufacturing a multi-chip package structure is provided. The package structure sequentially includes a first die layer, a second die layer, and a third die layer from top to bottom. The first die layer includes at least one first die, the second die layer includes at least one second die, and the third die layer includes at least one third die. The method includes: obtaining the first die layer and the second die layer; separately adding a hybrid bonding structure to a metal layer of the first die layer and a metal layer of the second die layer; connecting the first die layer to the second die layer to enable the first die layer to be electrically connected to the second die layer by using the hybrid bonding structure; obtaining the third die layer; separately fabricating a solder bump on a surface of the third die layer and a surface of the second die layer; and connecting the solder bump of the third die layer to the solder bump of the second die layer to implement an electrical connection between the second die layer and the third die layer by using the solder bump.

The first die layer is connected to the second die layer in a hybrid bonding manner. The third die layer is connected to the second die layer by using the solder bump. The first die layer is electrically connected to the third die layer by using the hybrid bonding structure, the plurality of TSVs, and the plurality of solder bumps. Stacked packaging of different processes and chips is implemented by combining the hybrid bonding structure, the solder bump, and the TSV Packaging of dies of different sizes and processes at the second die layer and the third die layer can be supported by using the solder bumps, flexibility of multi-chip packaging can be improved, and miniaturization of electronic device packaging can be further implemented.

Optionally, a feature size of a process used for the third die layer is smaller than that of the first die layer and that of the second die layer, and the third die layer includes a circuit used for edge computing. Further, optionally, the package structure is applied to an image sensor, the first die layer includes a chip on which an optical device is disposed, and the second die layer includes a logic chip.

In the method for manufacturing a multi-chip package structure, the feature size of the process used for the third die layer is smaller than that of the first die layer and that of the second die layer. Therefore, the third die layer has a smaller area and can integrate more functions. Because an area and the process of the third die layer are different from those of another die layer, the third die layer is connected to the second die layer by using the solder bump. In this package form, the third die layer may include the circuit that provides an edge computing function. The edge computing refers to a manner in which a signal collection end processes information. Therefore, the package structure may locally process at least some signals, and this can reduce an amount of data transmitted between the third die layer and a SoC. In addition, because the multi-chip package structure is no longer affected by transmission bandwidth, efficiency of locally processing data by the multi-chip package structure can be improved.

With reference to the second aspect, in a possible implementation, the method further includes: fabricating, at the second die layer, a plurality of TSVs that penetrate the second die layer.

With reference to the second aspect, in a possible implementation, the fabricating, at the second die layer, a plurality of TSVs that penetrate the second die layer includes fabricating the plurality of TSVs by using any one of the following processes: a TSV first process, a TSV middle process, and a TSV last process.

With reference to the second aspect, in a possible implementation, the method further includes: fabricating a redistribution layer RDL on a surface of the second die layer, and connecting the RDL to the metal layer of the second die layer by using at least one TSV of the second die layer.

With reference to the second aspect, in a possible implementation, the separately fabricating a solder bump on a surface of the third die layer and a surface of the second die layer includes: separately fabricating the solder bump on the surface of the third die layer and the RDL layer of the second die layer to implement the electrical connection between the third die layer and the second die layer by using the solder bump and the RDL.

With reference to the second aspect, in a possible implementation, the method further includes: thinning a substrate of the first die layer after the first die layer is connected to the second die layer; and fabricating an optical functional structure on the substrate of the first die layer.

According to a third aspect, an electronic device is provided, where the multi-chip package structure according to any one of the first aspect or the possible implementations of the first aspect is disposed in the electronic device.

### BRIEF DESCRIPTION OF DRAWINGS

FIG. 1 is a schematic diagram of a structure of dies connected in a fusion bonding (fusion bonding, FB) manner according to an embodiment of this application;
FIG. 2 is a schematic diagram of a structure of dies connected in a hybrid bonding (hybrid bonding, HB) manner according to an embodiment of this application;
FIG. 3 is a schematic diagram of a multi-chip package structure 300 according to an embodiment of this application;
FIG. 4 is a schematic diagram of a multi-chip package structure 400 according to an embodiment of this application;
FIG. 5 is a schematic diagram of a specific application of the multi-chip package structure 300 in FIG. 3;
FIG. 6 is a schematic diagram of a specific application of the multi-chip package structure 400 in FIG. 4;
FIG. 7 is a schematic diagram of a signal transmission path of the multi-chip package structure 300 in FIG. 3;
FIG. 8 is a schematic diagram of a signal transmission path of the multi-chip package structure 400 in FIG. 4; and
FIG. 9 is a schematic cross-sectional diagram of a manufacturing process of a multi-chip package structure according to an embodiment of this application.

### DESCRIPTION OF EMBODIMENTS

The following describes technical solutions of this application with reference to accompanying drawings. Several terms in embodiments of this application are first described.

An image sensor is an electronic device that uses an optical-to-electrical conversion function of a photoelectric device to convert an optical image on a photosensitive surface into an electrical signal in a corresponding proportion to the optical image. In other words, the image sensor is a device that converts the optical image into an electronic signal, and is widely used in digital cameras and other electronic optical devices. Image sensor products include a charge coupled device (charge-coupled device, CCD), a complementary metal-oxide semiconductor image sensor (complementary metal oxide semiconductor image sensor, CMOS image sensor, CIS), and the like.

A static random access memory (static random-access memory, SRAM) is a random access memory that stores data as long as the SRAM is powered on.

A dynamic random access memory (dynamic random-access memory, DRAM) is a random access memory that stores data that needs to be updated periodically.

A CIS is an image sensor implemented using a CMOS technology.

An application specific integrated circuit (application specific integrated circuit, ASIC) is an application specific integrated circuit designed to meet requirements of a specific user and a specific electronic system. In embodiments of this application, an ASIC chip may also be referred to as a customized logic chip.

A wafer is a silicon wafer used to make a silicon semiconductor integrated circuit.

A chip before packaging may be referred to as a die (die). The die may be an entire wafer, or may be a single chip obtained after the wafer is cut. In embodiments of this application, a front surface of the die is also referred to as an active surface or an active surface, and is a surface that is in the die and that is used to dispose an active device. Aback surface of the die is a surface in a direction of a substrate.

A chip (chip) may be a chip before packaging or a chip after packaging. In embodiments of this application, a definition of the chip covers the die (die).

Fusion bonding (fusion bonding, FB) means that two dies (dies) that need to be combined and packaged and that have a signal connection relationship are bonded by using a dielectric layer. For example, the dielectric layer may be silicon dioxide (SiO₂).

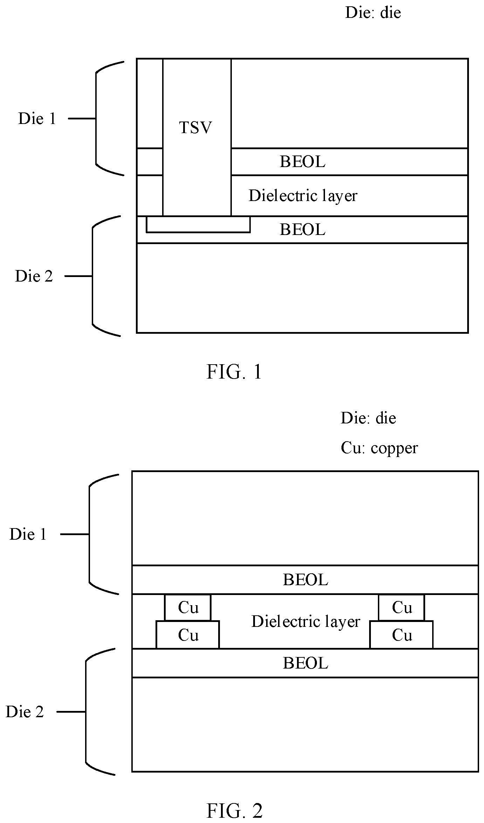

FIG. 1 is a schematic diagram of a structure of dies connected in a fusion bonding (FB) manner according to an embodiment of this application. As shown in FIG. 1, in the fusion bonding manner, an upper-layer die (die 1) and a lower-layer die (die 2) may be physically connected by using a dielectric layer. It should be noted that the fusion bonding (FB) is only used to implement a physical connection, and usually needs to pass through a bonding interface by using a TSV subsequently to implement an electrical connection.

A front end of line (front end of the line, FEOL) is also referred to as a front end of line of an integrated circuit, is a first part of process steps of the integrated circuit, and covers all processes before a metal interconnection layer is deposited.

A back end of line (back end of the line, BEOL) is also referred to as a back end of line of an integrated circuit, is a metal interconnection line part after a device is formed in an integrated circuit process, and may also be referred to as a metal layer. The BEOL may usually include one or more metal layers.

Hybrid bonding (hybrid bonding, HB) means that two die layers that have a signal connection relationship are connected in a chemical bonding manner. In a hybrid bonding technology, both a metal and an insulator are disposed on a bonding interface of the die. In a bonding process, metals on bonding interfaces of the two dies are aligned with each other, insulators on the bonding interfaces of the two dies are aligned with each other, and bonding is performed under a specific temperature condition.

FIG. 2 is a schematic diagram of a structure of dies connected in a hybrid bonding (HB) manner according to an embodiment of this application. As shown in FIG. 2, a BEOL of an upper-layer die (die 1) and a BEOL of a lower-layer die (die 2) are chemically bonded by using a dielectric layer. The dielectric layer includes metal copper (Cu) and an insulation substance.

Face to back (face to back, F2B) means that a back surface of a first die is connected to a front surface of a second die.

Face to face (face to face, F2F) means that a front surface of the first die is connected to the front surface of the second die.

Back to back (back to back, B2B) means that the back surface of the first die is connected to a back surface of the second die.

A substrate is also referred to as a package substrate, and is configured to: mechanically protect and support a chip, and implement an electrical connection between the chip and the outside. The substrate may include a metal substrate, a ceramic substrate, or an organic substrate.

A carrier wafer (carrier wafer) is configured to support a subsequent process in a semiconductor manufacturing process, and is usually removed after use. For example, when a wafer is thin, the carrier wafer may be used for support, and the carrier wafer may be made of a glass material or a silicon-based material.

A solder bump (bump) is a sphere that connects a die and a die or connects a die and a substrate, and may be made of a conductive material such as copper or tin. It should be noted that the solder bump may include a micro solder bump (micro-bump, Ubump).

A redistribution layer (redistribution layer) may be a connection wire disposed between a pad (pad) and a solder bump (bump) of a die. The redistribution layer is usually fabricated by using a Damascus process, or may be made of a polymer. The foregoing Damascus process is a process used for copper graphics in integrated circuit manufacturing. The polymer may be, for example, polyimide (polymide).

In a multi-chip packaging solution implemented by using the fusion bonding (FB) and a through silicon via (TSV) process, signal transmission between a plurality of dies needs to be implemented by completely using the TSV In this solution, sizes of dies at a plurality of chip layers need to be completely the same, and dies of different sizes or different processes cannot be supported. This limits flexibility of multi-chip packaging.

In this case, embodiments of this application propose a multi-chip package structure and an electronic device. The package structure provides a product form packaging method for three-dimensional chip stacking. Stacked packaging of a plurality of layers of different processes and different chips is implemented by combining hybrid bonding, a solder bump, and a TSV In this solution, packaging of dies of different sizes and processes can be supported, flexibility of multi-chip packaging can be improved, and miniaturization of a multi-chip package device is facilitated.

The multi-chip package structure in embodiments of this application may be applied to fields such as an image sensor and a memory. The multi-chip package structure may be applied to an electronic device, and an image sensor, a memory, or a chip with another function is disposed in the electronic device.

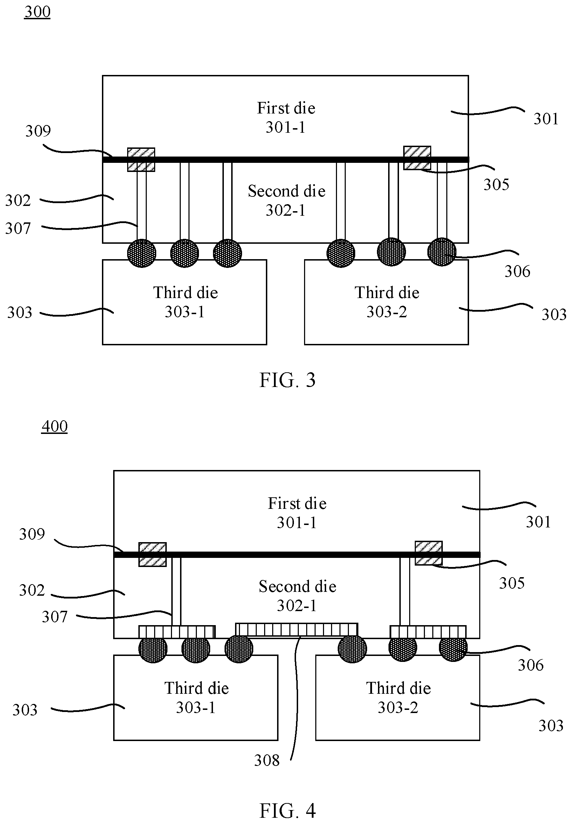

FIG. 3 is a schematic diagram of a multi-chip package structure 300 according to an embodiment of this application. The multi-chip package structure 300 is a package structure in which a plurality of chips are vertically stacked. As shown in FIG. 3, the multi-chip package structure 300 includes three die layers, which are sequentially a first die layer 301, a second die layer 302, and a third die layer 303 from top to bottom.

Optionally, the first die layer 301 may include one or more first dies 301-1, and the second die layer 302 may include one or more second dies 302-1. The third die layer 303 may include one or more third dies. For example, in FIG. 3, an example in which the third die layer 303 includes two third dies (303-1 and 303-2) is used for description. It should be understood that the third die layer 303 may include more or fewer dies.

A feature size of a process used for the third die layer 303 is smaller than that of the first die layer 301 and that of the second die layer 302, and the third die layer 303 may include a circuit configured to perform edge computing (edge processing). The edge computing is a manner of processing information by a signal collection end.

The foregoing feature size is a minimum size used in a semiconductor process. For example, the feature size used for the first die layer 301 and the second die layer 302 may be 18 nanometers (nm), and the feature size of the process used for the third die layer may be 7 nm.

It should be understood that a smaller feature size of a semiconductor process indicates more functions that can be provided by the semiconductor process in a same area.

A plurality of hybrid bonding structures 305 are disposed between the first die layer 301 and the second die layer 302 to enable the first die layer 301 to be electrically connected to the second die layer 302 by using the hybrid bonding (HB) structure 305.

The hybrid bonding structure 305 connects, in a chemical bonding manner, the first die layer 301 and the second die layer 302 that have a signal connection relationship. For a specific construction of the hybrid bonding structure 305, refer to the foregoing description about the hybrid bonding (HB) and the content in FIG. 2. Details are not described herein again.

Optionally, hybrid bonding may be performed between the first die layer 301 and the second die layer 302 in a face-to-face (F2F), face-to-back (F2B), or back-to-back (B2B) manner.

It should be understood that the first die layer 301 and the second die layer 302 may be manufactured by using a same process. Therefore, the first die layer 301 and the second die layer 302 are connected in a wafer-to-wafer (wafer to wafer, W2W) manner. The wafer-to-wafer connection is a process in which two chips are electrically connected in a wafer form, and are further cut into a plurality of units in a subsequent process.

A plurality of through silicon vias TSV 307 that penetrate the second die layer 302 are disposed at the second die layer 302, and a plurality of solder bumps 306 are disposed between the third die layer 303 and the second die layer 302. The first die layer 301 is electrically connected to the third die layer 303 by using at least one hybrid bonding structure 305, at least one TSV 307 electrically connected to the at least one hybrid bonding structure 305, and at least one solder bump 306 electrically connected to the at least one TSV 307.

The second die layer 302 may be electrically connected to the third die layer 303 by using at least one solder bump 306.

In this embodiment of this application, the feature size of the process used for the third die layer 303 is smaller than that of the first die layer 301 and that of the second die layer 302. The third die layer has a smaller area and can integrate more functions. For a case in which an area and the process of the third die layer 303 are different from those of another die layer, the third die layer 303 is connected to the second die layer 302 by using the solder bump. In this package form, the third die layer 303 may include the circuit that provides an edge computing function. The edge computing is computing performed by the signal collection end to process information. Therefore, the package structure may locally process at least some signals, and this can reduce an amount of data transmitted between the third die layer and a SoC. In addition, because the multi-chip package structure is no longer affected by transmission bandwidth, efficiency of locally processing data by the multi-chip package structure can be improved.

Because the third die layer 303 uses a more advanced process, compared with the other two die layers, the third die layer 303 can provide more functions such as original signal cropping, compression, and artificial intelligence (artificial intelligence, AI), and has lower power consumption and a faster processing speed. In the conventional technology, the functions need to be completed by relying on the SoC, and a signal needs to be transmitted to the master chip SoC through a mainboard for processing. This signal processing manner is limited by bandwidth of the mainboard and a processing capability of the SoC. Because all signals need to be transmitted to the SoC, this increases a signal transmission amount and load of the SoC. However, in this embodiment of this application, the third die layer 303 is integrated into the multi-chip package structure, so that a large amount of data can be quickly processed locally through edge computing. This reduces the load of the SoC and the signal transmission amount. In addition, the data is processed locally, which is not limited by the transmission bandwidth and is more efficient.

The third die layer 303 may be further configured to support a function that cannot be implemented in a conventional 3D packaging technology. For example, for an image sensor chip, multi-frame combination and compression may be performed on a picture in advance through edge computing, and the picture is transmitted to the SoC through the mainboard. This reduces an amount of data transmitted by the mainboard, that is, improves an image collection frequency or resolution under same mainboard bandwidth to implement high-definition slow-mo photography.

In this embodiment of this application, the first die layer 301 is connected to the second die layer 302 in a hybrid bonding (HB) manner. The third die layer 303 is connected to the second die layer 302 by using the solder bump 306. The first die layer 301 is connected to the third die layer 303 by using the hybrid bonding structure 305, the at least one TSV 307, and the at least one solder bump 306. Stacked packaging of different processes and chips is implemented by combining the hybrid bonding structure, the solder bump, and the TSV Packaging of dies of different sizes and processes at the second die layer 302 and the third die layer 303 can be supported by using the solder bumps 306, and flexibility of multi-chip packaging can be improved.

In addition, disposing a large quantity of TSVs in the die limits signal bandwidth and increases area consumption, and affects signal integrity and heat dissipation performance. However, in this embodiment of this application, signal transmission is implemented between the first die layer 301 and the second die layer 302 in the hybrid bonding manner, so that a quantity of TSVs disposed at the first die layer 301 is reduced, process steps and area overheads of the TSVs can be reduced, the signal bandwidth and signal quality can be improved, and the heat dissipation performance of the chip can be improved.

Optionally, a metal layer 309 is further disposed at the second die layer 302, and the metal layer 309 is interconnected to or electrically connected to the plurality of TSVs 307. The metal layer 309 may belong to a BEOL, that is, a metal interconnection part in a back end of line of an integrated circuit.

In some examples, the second die layer 302 is electrically connected to the third die layer 303 by using the metal layer 309, at least one TSV 307 electrically connected to the metal layer 309, and at least one solder bump 306 electrically connected to the at least one TSV

In some examples, if the third die layer 303 includes a plurality of third dies (303-1 and 303-2), the plurality of third dies (303-1 and 303-2) are electrically connected to each other by using the plurality of solder bumps 306, the plurality of TSVs 307, and the metal layer 309.

For example, the two third dies (303-1 and 303-2) are sequentially connected by using at least one solder bump 306, at least one TSV 307 electrically connected to the at least one solder bump 306, the metal layer 309 electrically connected to the at least one TSV 307, at least one other TSV 307 electrically connected to the metal layer 309, and at least one other solder bump 306 electrically connected to the at least one other TSV 307.

The at least one solder bump 306 and the at least one other solder bump 306 separately correspond to different third dies (303-1 and 303-2).

Optionally, the third die layer 303 may include the plurality of third dies (303-1 and 303-2), and the foregoing two third dies (303-1 and 303-2) may be any two third dies in the plurality of third dies (303-1 and 303-2)

In this embodiment of this application, the third die layer 303 is connected to the second die layer 302 by using the solder bump 306, the metal layer 309, and the TSV 307. Stacked packaging of different processes and chips is implemented by combining the hybrid bonding structure 305, the solder bump 306, the metal layer 309, and the TSV 307. Packaging of dies of different sizes and processes can be supported, flexibility of multi-chip packaging can be improved, and miniaturization of an electronic device is facilitated.

In some examples, the hybrid bonding manner is applicable to a scenario in which electrical connections between dies are dense, and the solder bump connection manner is applicable to a scenario in which electrical connections between dies are sparse.

Optionally, the multi-chip package structure 300 in this embodiment of this application may alternatively include more than three die layers. This is not limited in this embodiment of this application.

For example, the first die layer 301 may include any one of the following types of chips: a chip disposed with an optical device; a chip disposed with an SRAM; a chip disposed with a DRAM; a chip disposed with an ASIC; and a logic chip. The logic chip may include a general-purpose logic chip, or a chip disposed with an algorithm processing circuit.

For example, the second die layer 302 includes any one of the following types of chips: a chip disposed with an SRAM; a chip disposed with a DRAM; a chip disposed with an ASIC; and a logic chip.

For example, the third die layer 303 includes any one of the following types of chips: a logic chip; an ASIC chip; and a storage chip. The logic chip may include a general-purpose logic chip or another type of logic chip. The ASIC chip may include, for example, an image processing chip. The storage chip may include a DRAM chip, an SRAM chip, or a storage chip of another type.

In some examples, if the multi-chip package structure 300 is applied to an image sensor, the first die layer 301 may be a chip disposed with an optical device. The optical device may include a micro lens (micro lens) or another type of photosensitive circuit. The second die layer 302 may be a logic chip, and the logic chip may include an algorithm logic unit for processing an image. The third die layer 303 may include an ASIC chip. The ASIC chip may include, for example, an image processing chip. Alternatively, the third die layer 303 may include the circuit that provides the edge computing function. As described above, the large amount of data can be quickly processed locally. Compared with the conventional technology, an amount of data transmitted between the multi-chip package structure and the SoC can be reduced. In addition, because the multi-chip package structure is no longer affected by the transmission bandwidth, the efficiency of locally processing the data by the multi-chip package structure can be improved.

In some examples, if the multi-chip package structure 300 is applied to the memory, the first die layer 301 may be an SRAM chip, a DRAM chip, or a storage chip of another type. The second die layer 302 may be a logic chip. The third die layer 303 may include one or more ASIC chips. Optionally, locations of the first die layer 301 and the second die layer 302 may be interchanged. For example, the first die layer 301 includes the logic chip, and the second die layer 302 includes the SRAM chip, the DRAM chip, or the storage chip of another type.

Optionally, chip types in the first die layer 301 to the third die layer 303 are merely used as an example, and another type of chip may alternatively be disposed in the three die layers.

FIG. 4 is a schematic diagram of a multi-chip package structure 400 according to still another embodiment of this application. Compared with FIG. 3, a redistribution layer RDL 308 is disposed on a back surface of the second die layer 302 in the multi-chip package structure 400 in FIG. 4. The RDL 308 may be interconnected or electrically connected to the TSV 307. The RDL 308 may also be electrically connected to the solder bump 306 disposed between the second die layer 302 and the third die layer 303. For brevity, parts in FIG. 4 same as or similar to FIG. 3 are not described again.

As shown in FIG. 4, the first die layer 301 is electrically connected to the third die layer 303 by using at least one hybrid bonding structure 305, at least one TSV 307 electrically connected to the at least one hybrid bonding structure 305, the RDL 308 electrically connected to the at least one TSV 307, and the plurality of solder bumps 306.

The second die layer 302 is electrically connected to the third die layer 303 by using the RDL 308 and the plurality of solder bumps 306.

In some examples, if the third die layer 303 includes a plurality of dies (303-1 and 303-2), the plurality of third dies (303-1 and 303-2) are sequentially electrically connected to each other by using the plurality of solder bumps 306, the RDL 308, and the plurality of solder bumps 306.

For example, the third die layer 303 includes two third dies (303-1 and 303-2), the two third dies (303-1 and 303-2) are sequentially electrically connected to each other by using at least one solder bump 306, the RDL 308 electrically connected to the at least one solder bump 306, and at least one other solder bump 306 electrically connected to the RDL 308.

The at least one solder bump 306 and the at least one other solder bump 306 separately correspond to different third dies (303-1 and 303-2).

Optionally, the metal layer 309 is disposed at the second die layer 302, and the metal layer 309 is interconnected to or electrically connected to the plurality of TSVs 307.

In some examples, the first die layer 301 is electrically connected to the third die layer 303 by using the hybrid bonding structure 305, the metal layer 309, the plurality of TSVs 307, the RDL 308, and the plurality of solder bumps 306.

Optionally, the RDL may be implemented by using polyimide (polymide). Alternatively, copper interconnection may be implemented by using a Damascus process, or aluminum interconnection may be implemented. The foregoing materials can reduce product costs and have a strong power supply capability.

Optionally, when the multi-chip package structure is applied to a scenario that has a high requirement on a signal frequency, the RDL 308 may be fabricated at the second die layer 302. When the multi-chip package structure is applied to a scenario that has a low requirement on a signal frequency, the RDL 308 may not need to be fabricated. This reduces process costs and design complexity.

In this embodiment of this application, signal transmission is implemented between the first die layer 301 and the second die layer 302 in the hybrid bonding manner, so that a quantity of TSVs 307 disposed at the first die layer 301 is reduced. In addition, the RDL 308 is disposed at the second die layer 302, and this enables signal transmission to be implemented, by using the RDL 308, between the second die layer 302 and the third die layer 303, or between the plurality of third dies (303-1 and 303-2) at the third die layer 303, so that the multi-chip package structure is applicable to a scenario that has a high requirement on a signal frequency. In addition, a quantity of TSVs disposed at the second die layer 302 is reduced, process steps and area overheads of the TSVs can be reduced, signal bandwidth and signal quality can be improved, and heat dissipation performance of a chip can be improved.

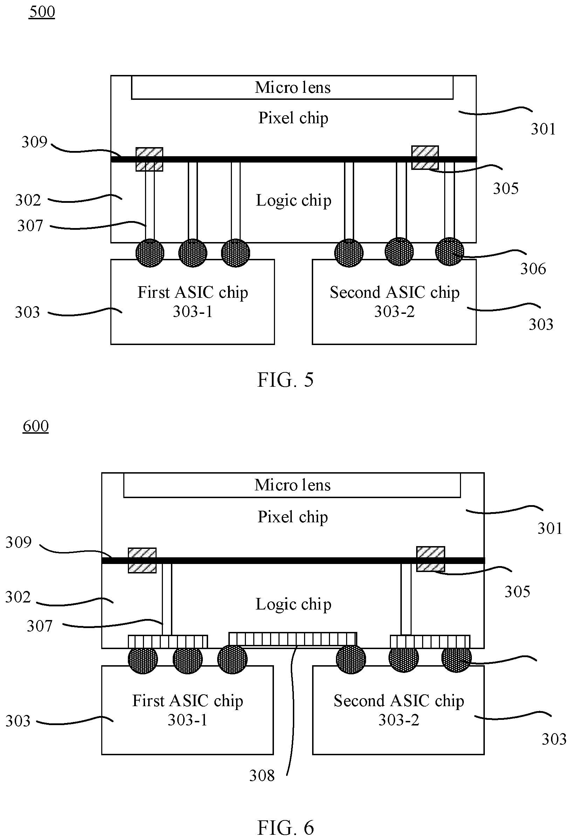

FIG. 5 is a schematic diagram of a specific application of the multi-chip package structure 300 in FIG. 3. The multi-chip package structure 500 shown in FIG. 5 may be applied to an image sensor, and is the same as the structure of the multi-chip package structure 300 in FIG. 3.

Specifically, as shown in FIG. 5, the first die layer 301 may be a chip disposed with an optical device. For example, the optical device may include a micro lens (micro lens). The chip disposed with the optical device may also be referred to as a pixel chip.

The second die layer 302 may be a logic chip. The third die layer 303 may include one or more ASIC chips. In FIG. 5, an example in which the third die layer 303 includes a first ASIC chip 303-1 and a second ASIC chip 303-2 is used for description.

FIG. 6 is a schematic diagram of a specific application of the multi-chip package structure 400 in FIG. 4. The multi-chip package structure 600 shown in FIG. 6 may be applied to an image sensor, and is the same as the structure of the multi-chip package structure 400.

Specifically, as shown in FIG. 6, the first die layer 301 may be a chip disposed with an optical device. For example, the optical device may include a micro lens (micro lens). The chip disposed with the optical device may also be referred to as a pixel chip.

The second die layer 302 may be a logic chip. The third die layer 303 may include one or more customized logic chips. In FIG. 6, an example in which the third die layer 303 includes a first ASIC chip 303-1 and a second ASIC chip 303-2 is used for description.

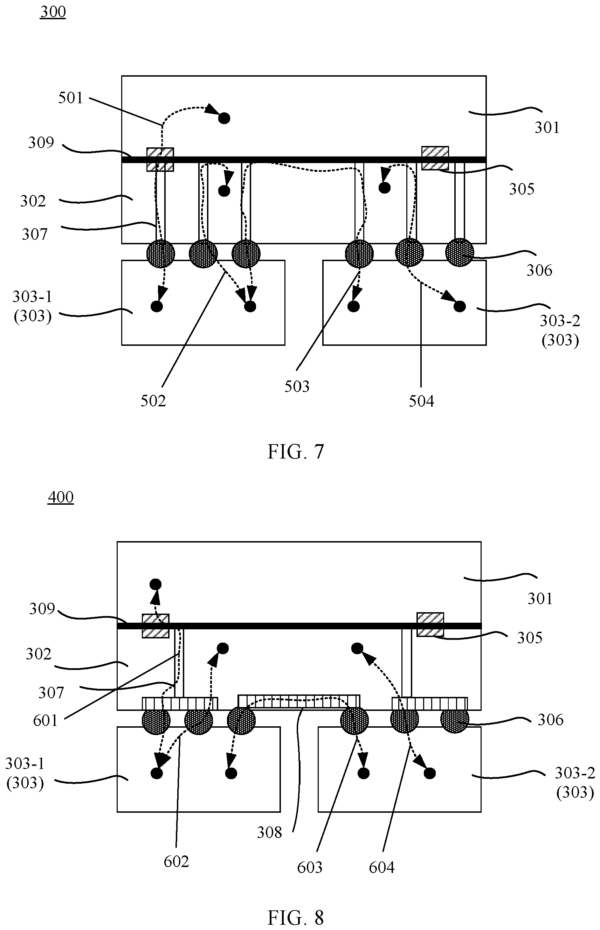

FIG. 7 is a schematic diagram of a signal transmission path of the multi-chip package structure 300 in FIG. 3. As shown in FIG. 7, a first path 501 represents a signal transmission path between the first die layer 301 and the third die 303-1 at the third die layer 303. The first path 501 starts from the first die layer 301 to the die 303-1 via at least one hybrid bonding structure 305, at least one TSV 307 electrically connected to the at least one hybrid bonding structure 305, and at least one solder bump 306 electrically connected to the at least one TSV 307.

Optionally, when the at least one TSV 307 is electrically connected to the at least one hybrid bonding structure 305 by using the metal layer 309, the first path 501 starts from the first die layer 301 to the third die 303-1 via the at least one hybrid bonding structure 305, the metal layer 309 electrically connected to the at least one hybrid bonding structure 305, the at least one TSV 307 electrically connected to the metal layer 309, and the at least one solder bump 306 electrically connected to the at least one TSV 307.

A second path 502 represents a signal transmission path between the second die layer 302 and the third die 303-1 at the third die layer 303. The second path 502 starts from the second die layer 302 to the third die 303-1 via the metal layer 309, at least one TSV 307 electrically connected to the metal layer 309, and at least one solder bump 306 electrically connected to the at least one TSV 307.

Athird path 503 represents a signal transmission path between the plurality of third dies (303-1 and 303-2) at the third die layer. The third path 503 starts from the third die 303-1 to the third die 303-2 via at least one solder bump 306, at least one TSV 307 electrically connected to the at least one solder bump 306, the metal layer 309 electrically connected to the at least one TSV 307, at least one other TSV 307 electrically connected to the metal layer 309, and at least one other solder bump 306 electrically connected to the at least one other TSV 307.

A fourth path 504 represents a signal transmission path between the second die layer 302 and the die 303-2 at the third die layer 303. The fourth path 504 is similar to the second path 502. Details are not described herein again.

FIG. 8 is a schematic diagram of a signal transmission path of the multi-chip package structure 400 in FIG. 4. As shown in FIG. 8, a first path 601 represents a signal transmission path between the first die layer 301 and the third die 303-1 at the third die layer 303. The first path 601 starts from the chip 301 to the third die 303-1 via at least one hybrid bonding structure 305, at least one TSV 307 electrically connected to the at least one hybrid bonding structure 305, the RDL 308 electrically connected to the at least one TSV 307, and at least one solder bump 306 electrically connected to the RDL 308.

Optionally, when the plurality of TSVs 307 are electrically connected to the hybrid bonding structure 305 by using the metal layer 309, the first path 601 starts from the first die layer 301 to the third die 303-1 via the at least one hybrid bonding structure 305, the metal layer 309 electrically connected to the at least one hybrid bonding structure 305, the at least one TSV 307 electrically connected to the metal layer 309, the RDL 308 electrically connected to the at least one TSV 307, and the at least one solder bump 306 electrically connected to the RDL 308.

A second path 602 represents a signal transmission path between the second die layer 302 and the third die 303-1 at the third die layer 303. The second path 602 starts from the second die layer 302 to the third die 303-1 via the RDL 308 and at least one solder bump 306 electrically connected to the RDL 308.

A third path 603 represents a signal transmission path between the plurality of dies (303-1 and 303-2) at the third die layer. The third path 603 starts from the third die 303-1 to the die 303-2 via at least one solder bump 306 on the third die 303-1, the RDL 308 electrically connected to the at least one solder bump 306, and at least one other solder bump 306 on the third die 303-2.

A fourth path 604 represents a signal transmission path between the second die layer 302 and the third die 303-2 at the third die layer 303. The fourth path is similar to the second path. Details are not described herein again.

The following continues to describe a manufacturing process of the multi-chip package structure in embodiments of this application with reference to the accompanying drawings.

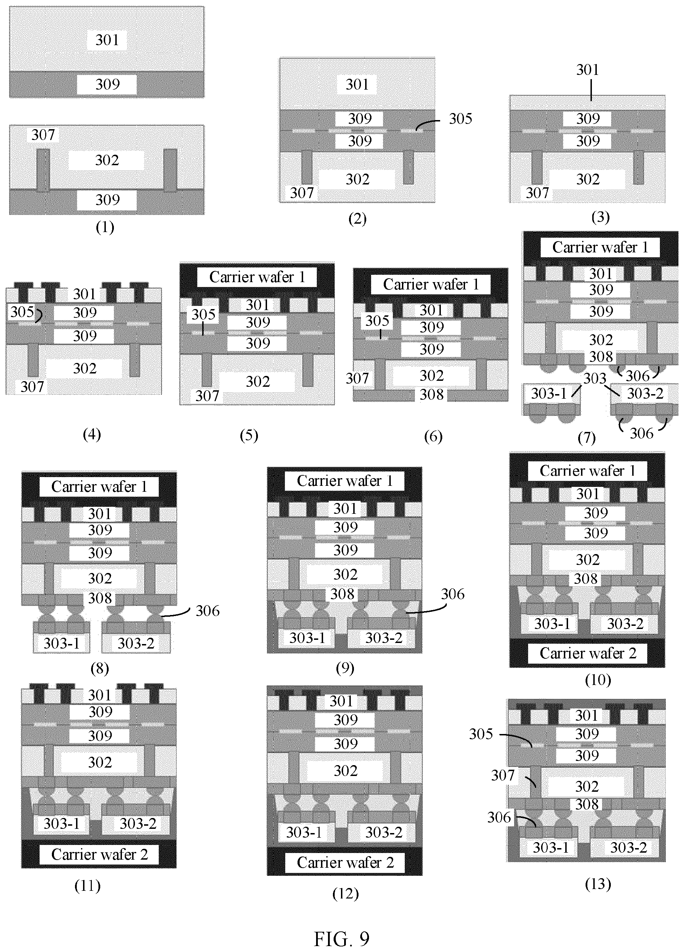

FIG. 9 is a schematic cross-sectional diagram of a manufacturing process of a multi-chip package structure according to an embodiment of this application. In FIG. 9, a manufacturing process of the multi-chip package structure 400 in FIG. 4 is used as an example for description. It should be understood that after limited transformation, for example, steps are added, steps are reduced, or some steps are replaced, the manufacturing process may also be applied to a manufacturing process of another multi-chip package structure in embodiments of this application.

(1) to (13) in FIG. 9 show the manufacturing process of the multi-chip package structure 400. With reference to FIG. 9, the manufacturing process of the multi-chip package structure 400 is described by using steps S1 to S13.

It should be noted that, in steps S1 to S12, the first die layer 301 and the second die layer 302 are in a wafer form, and in step S13, the first die layer 301 and the second die layer 302 are single chips after cutting. In steps S7 to S13, the third die layers (303-1 and 303-2) are single chips after cutting.

S1: As shown in (1) in FIG. 9, first obtain the first die layer 301 and the second die layer 302.

Optionally, in S1, the second die layer 302 may be a die layer on which the TSV 307 has been fabricated in advance. Alternatively, in steps S1 to S5, the second die layer 302 that does not have the TSV 307 is used, and the TSV 307 is fabricated at the second die layer 302 after S5.

S2: As shown in (2) in FIG. 9, add a hybrid bonding structure 305 to each of the metal layer 309 of the first die layer 301 and the metal layer 309 of the second die layer 302, where the hybrid bonding structure 305 includes a metal and an insulating substance for wrapping the metal. For example, the metal may include Cu, and the insulation substance may include SiO₂, silicon nitride (SiN), and the like. Then, the first die layer 301 is reversed by 180 degrees, so that the first die layer 301 and the second die layer 302 are interconnected through the metal layers 309. In other words, the first die layer 301 is connected to the second die layer 302 in a face-to-face (F2F) connection manner. It should be noted that the first die layer 301 may alternatively be connected to the second die layer 302 in a face-to-back (F2B) or back-to-back (B2B) manner. Electrical connection is implemented between the first die layer 301 and the second die layer 302 in a hybrid bonding manner.

S3: As shown in (3) in FIG. 9, thin a substrate of the first die layer 301 to reach a preset thickness of the first die layer 301. The thickness may be determined based on an actual requirement. This is not specifically limited in this embodiment of this application.

S4: As shown in (4) in FIG. 9, optionally, further fabricate a structure, for example, a metal layer and another function layer (for example, an optical function structure), on the substrate of the first die layer 301, and expose the metal at the first die layer 301 as a metal pad (pad) in an etching manner.

In some other scenarios, after the metal at the first die layer 301 is exposed in the etching manner, the metal pad (pad) may be further fabricated, and the metal pad is connected to the exposed metal at the first die layer 301. The metal pad may be further interconnected in a subsequent process. For example, the metal pad is connected to the substrate through wire bonding (wire bond) or flip chip (flip chip, FC).

S5: As shown in (5) in FIG. 9, bond an upper carrier wafer (identified as a carrier wafer 1) on a surface of the substrate at the first die layer 301, where the carrier wafer 1 is configured to: protect the surface of the first die layer 301, and play a supporting role in the subsequent process.

S6: As shown in (6) in FIG. 9, thin the second die layer 302, fabricate the redistribution layer RDL 308 on the back surface of the second die layer 302, and connect the RDL 308 to the metal layer 309 of the second die layer 302 by using at least one TSV 307.

In some examples, the TSV 307 of the second die layer 302 may be first fabricated in S1. A TSV fabrication process may use a TSV first (through silicon via first) process or a TSV middle (through silicon via mid) process. In this step, the second die layer 302 is first thinned, the TSV 307 is exposed by using a standard TSV backside via reveal (through silicon back side via reveal, BVR) process, and the RDL 308 is fabricated.

In other examples, the TSV may not be fabricated in S1. In this step S6, the second die layer 302 is first thinned, the TSV 307 is fabricated by using a TSV last (through silicon via last) process, and then the RDL 308 is fabricated.

The TSV first process may mean that a TSV hole is fabricated first, and then a circuit is fabricated. The TSV middle process may mean that a circuit and a part of a metal layer are first fabricated, then a TSV is fabricated, and finally a remaining TSV is fabricated. The TSV last process may mean that a circuit and a metal layer are first fabricated, and finally a TSV is fabricated.

S7: As shown in (7) in FIG. 9, test the fabricated dies (303-1 and 303-2) at the third layer, and select chips with normal functions as the third die layers (303-1 and 303-2). A die with a normal test result is called (know good die, KGD). Solder bumps 306 are separately added on surfaces of the third die layers (303-1 and 303-2) and the RDL 308 of the second die layer 302.

S8: As shown in (8) in FIG. 9, connect solder bumps 306 of the third die layers (303-1 and 303-2) to solder bumps 306 of the second die layer 302. An electrical connection between the third die layers (303-1 and 303-2) and the second die layer 302 is implemented by using the solder bumps 306 and the RDL 308 of the second die layer 302. In addition, signal transmission between the third die layers (303-1 and 303-2) and the first die layer 301 may be implemented by using the TSV 307 that penetrates the second die layer 302.

S9: As shown in (9) in FIG. 9, package protection is performed on the third die layer (303-1 and 303-2), for example, by using underfill (underfill), a non-conductive film (non-conductive film, NCF), plastic packaging resin (epoxy molding compound, EMC), or another material.

S10: As shown in (10 in FIG. 9), add a carrier wafer (identified as a carrier wafer 2) to bottom layers of the third die layers (303-1 and 303-2) as a protective layer.

S11: As shown in (11) in FIG. 9, remove the carrier wafer (that is, the carrier wafer 1) at the first die layer 301.

S12: As shown in (12) in FIG. 9, perform further processing on the back surface of the first die layer 301 based on different chip functions, for example, add an optical device. The optical device may be, for example, a color filter (color filter), a micro lens (micro lens), or an anti-reflection film (anti-reflection film).

S13: As shown in (13) in FIG. 9, remove the carrier wafer (identified as the carrier wafer 2) at the bottom layers of the third die layers (303-1 and 303-2) to obtain a multi-chip package structure, where the multi-chip package structure is a chip packaged in a three-layer stacked structure.

Optionally, after S13, the obtained multi-chip package structure may be further integrated, for example, may be integrated into another package through the wire bonding (wire bond) or flip chip (FC). A subsequent packaging process is not limited in this embodiment of this application.

Optionally, if a technological process of the multi-chip package structure 300 in FIG. 3 is implemented, based on the technological process in FIG. 9, the step of fabricating the redistribution layer RDL may be omitted. In other words, the RDL 308 in the second die layer 302 is not fabricated, so that the TSV 307 is directly connected to the solder bump 306 and the metal layer 309 of the die 301. In other words, in the fabricating process in FIG. 9, the step of the redistribution layer is removed, and signal transmission between the third die layers (303-1 and 303-2) and the second die layer 302 is implemented by using the TSV 307 and the solder bumps 306. In this way, the process step of the RDL 308 is reduced.

In this embodiment of this application, a signal is transmitted between the first die layer 301 and the second die layer 302 in the hybrid bonding manner, and the second die layer 302 is connected to the third die layers (303-1 and 303-2) by using the solder bumps. Therefore, sizes and techniques of the second die layer 302 and the third die layers (303-1 and 303-2) do not need to be completely the same. In this way, technology nodes and the sizes of the second die layer 302 and the third die layers (303-1 and 303-2) can be flexibly selected, flexibility of the multi-chip package structure can be improved, and miniaturization of an electronic device is facilitated.

The foregoing description is merely a specific implementation of this application, but is not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A multi-chip package structure, wherein the package structure sequentially comprises a first die layer, a second die layer, and a third die layer from top to bottom, wherein the first die layer comprises at least one first die, the second die layer comprises at least one second die, and the third die layer comprises at least one third die;
a plurality of hybrid bonding structures are disposed between the first die layer and the second die layer to enable the first die layer to be electrically connected to the second die layer by using at least one hybrid bonding structure; and
a plurality of through silicon vias TSV that penetrate the second die layer are disposed at the second die layer, a plurality of solder bumps are disposed between the third die layer and the second die layer, and the first die layer is electrically connected to the third die layer by using at least one hybrid bonding structure, at least one TSV electrically connected to the at least one hybrid bonding structure, and at least one solder bump electrically connected to the at least one TSV

2. The package structure according to claim 1, further comprising a metal layer disposed at the second die layer, wherein the plurality of TSVs are electrically connected to the metal layer; and the first die layer is electrically connected to the third die layer by using the at least one hybrid bonding structure, the metal layer electrically connected to the at least one hybrid bonding structure, at least one TSV electrically connected to the metal layer, and at least one solder bump electrically connected to the at least one TSV

3. The package structure according to claim 1 or 2, wherein the second die layer is electrically connected to the third die layer by using the metal layer, the at least one TSV electrically connected to the metal layer, and the at least one solder bump electrically connected to the at least one TSV

4. The package structure according to claim 2 or 3, wherein the third die layer comprises two third dies; and the two third dies are sequentially connected by using at least one solder bump, at least one TSV electrically connected to the at least one solder bump, the metal layer electrically connected to the at least one TSV, at least one other TSV electrically connected to the metal layer, and at least one other solder bump electrically connected to the at least one other TSV

5. The package structure according to claim 1, wherein a redistribution layer RDL is disposed at the second die layer; and the first die layer is electrically connected to the third die layer by using at least one hybrid bonding structure, at least one TSV electrically connected to the at least one hybrid bonding structure, the RDL electrically connected to the at least one TSV, and at least one solder bump electrically connected to the RDL.

6. The package structure according to claim 5, wherein the second die layer is electrically connected to the third die layer by using the RDL and the at least one solder bump electrically connected to the RDL.

7. The package structure according to claim 5 or 6, wherein the third die layer comprises two third dies; and the two third dies are electrically sequentially connected by using at least one solder bump, the RDL electrically connected to the at least one solder bump, and at least one other solder bump electrically connected to the RDL.

8. The package structure according to any one of claims 5 to 7, wherein the plurality of TSVs are electrically connected to a metal layer disposed at the second die layer; and the first die layer is electrically connected to the third die layer by using the at least one hybrid bonding structure, the metal layer electrically connected to the at least one hybrid bonding structure, at least one TSV electrically connected to the metal layer, the RDL electrically connected to the at least one TSV, and at least one solder bump electrically connected to the at least one TSV

9. The package structure according to any one of claims 1 to 8, wherein the third die layer comprises a circuit configured to provide an edge computing function.

10. The package structure according to any one of claims 1 to 9, wherein a feature size of a process used for the third die layer is smaller than that of the first die layer and that of the second die layer.

11. The package structure according to any one of claims 1 to 10, wherein the package structure is applied to an image sensor, the first die layer comprises a chip on which an optical device is disposed, and the second die layer comprises a logic chip.

12. A method for manufacturing a multi-chip package structure, wherein the package structure sequentially comprises a first die layer, a second die layer, and a third die layer from top to bottom, wherein the first die layer comprises at least one first die, the second die layer comprises at least one second die, and the third die layer comprises at least one third die; and the method comprises:
obtaining the first die layer and the second die layer;
separately adding a hybrid bonding structure to a metal layer of the first die layer and a metal layer of the second die layer;
connecting the first die layer to the second die layer to enable the first die layer to be electrically connected to the second die layer by using the hybrid bonding structure;
obtaining the third die layer;
separately fabricating a solder bump on a surface of the third die layer and a surface of the second die layer; and
connecting the solder bump of the third die layer to the solder bump of the second die layer to implement an electrical connection between the second die layer and the third die layer by using the solder bump.

13. The method according to claim 12, further comprising: fabricating, at the second die layer, a plurality of through silicon vias TSV that penetrate the second die layer.

14. The method according to claim 13, wherein the fabricating, at the second die layer, a plurality of TSVs that penetrate the second die layer comprises fabricating the plurality of TSVs by using any one of the following processes: a TSV first process, a TSV middle process, and a TSV last process.

15. The method according to claim 13 or 14, wherein the method further comprises:
fabricating a redistribution layer RDL on a surface of the second die layer, and connecting the RDL to the metal layer of the second die layer by using at least one TSV of the second die layer.

16. The method according to claim 15, wherein the separately fabricating a solder bump on a surface of the third die layer and a surface of the second die layer comprises:
separately fabricating the solder bump on the surface of the third die layer and the RDL layer of the second die layer to implement the electrical connection between the third die layer and the second die layer by using the solder bump and the RDL.

17. The method according to any one of claims 12 to 16, wherein the method further comprises:
thinning a substrate of the first die layer after the first die layer is connected to the second die layer; and
fabricating an optical functional structure on the substrate of the first die layer.

18. The method according to any one of claims 12 to 17, wherein the third die layer comprises a circuit configured to provide an edge computing function.

19. The method according to any one of claims 12 to 18, wherein a feature size of a process used for the third die layer is smaller than that of the first die layer and that of the second die layer.

20. The method according to any one of claims 12 to 19, wherein the package structure is applied to an image sensor, the first die layer comprises a chip on which an optical device is disposed, and the second die layer comprises a logic chip.

21. An electronic device, wherein the multi-chip package structure according to any one of claims 1 to 11 is disposed in the electronic device.
